# EUROPEAN PATENT SPECIFICATION

(11) **EP 2 930 744 B1**
(45) Date of publication and mention of the grant of the patent: **14.04.2021**
(21) Application number: 13860184.4
(22) Date of filing: 04.12.2013
(51) Int. Cl.: H01L 23/373, B23K 1/00, B23K 35/30, H01L 23/42, H05K 1/03, C04B 35/645, C04B 37/02, H05K 3/38, B23K 35/02, H01L 23/433

(54) **SUBSTRATE FOR POWER MODULES, SUBSTRATE WITH HEAT SINK FOR POWER MODULES AND POWER MODULE**
SUBSTRAT FÜR LEISTUNGSMODULE, SUBSTRAT MIT KÜHLKÖRPER FÜR LEISTUNGSMODULE UND LEISTUNGSMODUL
SUBSTRAT POUR MODULES DE PUISSANCE, SUBSTRAT AVEC DISSIPATEUR THERMIQUE POUR MODULES DE PUISSANCE ET MODULE DE PUISSANCE

(30) Priority: 06.12.2012 JP 2012267300
(43) Date of publication of application: 14.10.2015
(73) Proprietor: Mitsubishi Materials Corporation, Chiyoda-ku Tokyo 100-8117 (JP)
(72) Inventor: TERASAKI, Nobuyuki, Kitamoto-shi Saitama 364-0022 (JP); NAGATOMO, Yoshiyuki, Kitamoto-shi Saitama 364-0022 (JP); NISHIKAWA, Kimihito, Sunto-gun Shizuoka 410-1312 (JP)
(74) Representative: Hoffmann Eitle
(86) International application number: PCT/JP2013/082568
(87) International publication number: WO 2014/088025

(56) References cited:
- WO-A1-2013/094213
- JP-A- H0 234 579
- JP-A- S6 342 153
- JP-A- H06 342 853
- JP-A- 2003 204 021
- JP-A- 2011 181 847
- US-A- 5 354 415
- US-B1- 6 284 985
- JOSEPH A PASK: "From Technology to the Science of Glass/Metal and Ceramic/Metal Sealing", AMERICAN CERAMIC SOCIETY BULLETIN,, vol. 66, no. 11, 1 November 1987 (1987-11-01), pages 1587-1592, XP001351504,
- KOLENAK R ET AL: "JOINING OF CERAMIC MATERIALS WITH ACTIVE FILLER METAL", WELDING IN THE WORLD, SPRINGER, vol. 45, 1 July 2001 (2001-07-01), pages 169-175, XP001101239, ISSN: 0043-2288

## Description

### FIELD OF THE INVENTION

The present invention relates to a power module substrate used in a semiconductor element that controls a large current and a high voltage, a power module substrate with a heat sink, and a power module.

### BACKGROUND OF THE INVENTION

Among semiconductor elements, a power module that supplies electric power has a relatively high amount of heat generation. Therefore, as a substrate on which the power module is mounted, for example, a power module substrate, which is provided with a ceramic substrate formed of AlN (aluminum nitride), Al₂O₃ (alumina), Si₃N₄ (silicon nitride), or the like, a circuit layer that is formed by bonding a first metal plate onto one surface of the ceramic substrate, and a metal layer that is formed by bonding a second metal plate onto the other surface of the ceramic substrate, is used.

In the above-described power module substrate, a semiconductor element such as a power device is mounted on the circuit layer through a solder material.

For example, a power module substrate which is formed by using an aluminum sheet as the first metal plate (circuit layer) and the second metal plate (metal layer) is proposed in Patent Literature 1 (PTL 1).

In addition, a power module substrate which is formed by using a copper sheet as the first metal plate (circuit layer) and the second metal plate (metal layer) and by bonding the copper sheet onto the ceramic substrate according to an active metal method using an Ag-Cu-Ti-based brazing material is proposed in PTLs 2 and 3.

### [Related Art Documents]

### [Patent Literature]

[PTL 1] Japanese Patent (Granted) Publication No. 3171234
[PTL 2] Japanese Unexamined Patent Application, First Publication No. S60-177634
[PTL 3] Japanese Patent (Granted) Publication No. 3211856

### [Problems to be Solved by the Present Invention]

However, in the power module substrate described in PTL 1, the aluminum sheet is used as the first metal plate that forms the circuit layer. When cases using copper and aluminum are compared, the thermal conductivity of aluminum is lower than that of copper. Accordingly, in the case of using an aluminum sheet as the circuit layer, heat from a heat generating body such as an electrical component or the like which is mounted on the circuit layer cannot be spread and dissipated as good as in the case of using a copper sheet. Therefore, in a case in which power density is increased due to down-sizing and increasing of the output of an electronic component, there is a concern that heat cannot be sufficiently dissipated.

In PTL 2 and PTL 3, since the circuit layer is formed by the copper sheet, heat from the heat generating body such as the electrical component that is mounted on the circuit layer can be effectively dissipated.

However, as described in PTL 2 and PTL 3, when the copper sheet and the ceramic substrate are bonded by the active metal method, an Ag-Cu eutectic structure layer is formed by melting and solidifying the Ag-Cu-Ti-based brazing material at a portion in which the copper sheet and the ceramic substrate are bonded to each other.

The Ag-Cu eutectic structure layer is very hard. Thus, in a case in which shear stress caused by a difference in thermal expansion coefficient between the ceramic substrate and the copper sheet is applied during loading of a thermal cycle, the Ag-Cu eutectic structure layer is not deformed and there is a problem in that cracking or the like occurs in the ceramic substrate.

The present invention has been made in consideration of the above-described circumstances, and an object thereof is to provide a power module substrate obtained by bonding a copper sheet made of copper or a copper alloy to a ceramic substrate made of Al₂O₃ and capable of suppressing occurrence of cracking in the ceramic substrate during loading a thermal cycle. In addition, a power module substrate with a heat sink, and a power module, with the above-mentioned power module substrate are providec WO2013/094213 discloses the joining of a ceramic substrate with a copper plate using a brazing paste based on Ag-Cu-Ti. The paste layer has a thickness of 10 microns. The substrate is part of a power module that contains a chip.

### SUMMARY OF THE INVENTION

### [Means to Solving the Problems]

(1) The first aspect of the present invention is a power module substrate including: a ceramic substrate made of Al₂O₃; and a copper sheet made of copper or a copper alloy laminated and bonded onto a surface of the ceramic substrate, wherein an oxide layer is formed on the surface of the ceramic substrate between the copper sheet and the ceramic substrate, an Ag-Cu eutectic structure layer is formed on the oxide layer, a thickness of the Ag-Cu eutectic structure layer is 15 µm or less, and the oxide layer contains oxides of one or more elements selected from Ti, Hf, Zr, and Nb.
   In the power module substrate having the above-described configuration, since the thickness of the Ag-Cu eutectic structure layer is set to 15 µm or less at a portion in which the copper sheet formed of copper or a copper alloy and the ceramic substrate made of Al₂O₃ are bonded to each other, the copper sheet is appropriately deformed even when shear stress caused by a difference in thermal expansion coefficient between the ceramic substrate made of Al₂O₃ and the copper sheet is applied during loading of a thermal cycle. Thus, it is possible to suppress occurrence of cracking or the like in the ceramic substrate made of Al₂O₃.
   Further, an oxide layer is formed on the surface of the ceramic substrate by reaction with oxygen contained in the ceramic substrate made of Al₂O₃ and thus, the ceramic substrate and the oxide layer can be firmly joined.
   In the power module substrate according to above-described (1), the oxide layer contains oxides of one or more elements selected from Ti, Hf, Zr, and Nb.
   In this case, since the ceramic substrate and the oxide layer are firmly joined to each other, the ceramic substrate and the copper sheet can be firmly bonded.
(2) Other aspect of the present invention is a power module substrate with a heat sink including: the power module substrate according to the above-described (1); and a heat sink which is configured to cool the power module substrate.
   According to the power module substrate with a heat sink having the above-described configuration, heat generated in the power module substrate can be dissipated by a heat sink. In addition, since the copper sheet and the ceramic substrate are reliably bonded, the heat from the power module substrate can be reliably transferred to the heat sink.
(3) Other aspect of the present invention is a power module including: the power module substrate according to the above-described (1); and an electronic component which is mounted on the power module substrate.

According to the power module having the above-described configuration, heat from the electronic component that is mounted on the power module substrate can be effectively dissipated and even when the power density (the amount of heat generation) of the electronic component is improved, it is possible to sufficiently cope with this situation.

### [Effects of the Invention]

According to the present invention, it is possible to provide a power module substrate obtained by bonding a copper sheet made of copper or a copper alloy to a ceramic substrate made of Al₂O₃ and capable of suppressing occurrence of cracking in the ceramic substrate during loading of a thermal cycle. In addition, a power module substrate with a heat sink, and a power module, having the above-described power module substrate can be provided.

### BRIEF DESCRIPTION OF DRAWINGS

FIG. 1 is a schematic explanatory diagram of a power module substrate, a power module substrate with a heat sink using the power module substrate, and a power module according to the first embodiment of the present invention.
FIG. 2 is an enlarged explanatory diagram of a bonding interface between a circuit layer and a ceramic substrate made of Al₂O₃ in FIG. 1.
FIG. 3 is a flow chart illustrating a method of producing a paste for copper sheet bonding containing Ag and an oxide-forming element used in bonding a copper sheet serving as a circuit layer and a ceramic substrate in the first embodiment of the present invention.
FIG. 4 is a flow chart illustrating a method of producing the power module substrate and the power module substrate with a heat sink using the power module substrate according to the first embodiment of the present invention.
FIG. 5 is an explanatory diagram illustrating the method of producing the power module substrate and the power module substrate with a heat sink using the power module substrate according to the first embodiment of the present invention.
FIG. 6 is an enlarged explanatory diagram illustrating a bonding process of bonding the ceramic substrate and the copper sheet.
FIG. 7 is a schematic explanatory diagram of a power module substrate according to the second embodiment of the present invention.
FIG. 8 is an enlarged explanatory diagram of a bonding interface between a circuit layer and a metal layer or a ceramic substrate in FIG. 7.
FIG. 9 is a flow chart illustrating a method of producing the power module substrate according to the second embodiment of the present invention.
FIG. 10 is an explanatory diagram illustrating a method of producing the power module substrate according to the second embodiment of the present invention.
FIG. 11 is an explanatory diagram illustrating a method of producing a power module substrate and a power module substrate with a heat sink using the power module substrate according to other embodiment of the present invention.
FIG. 12 is an explanatory diagram illustrating a method of producing a power module substrate and a power module substrate with a heat sink using the power module substrate according to other embodiment of the present invention.
FIG. 13 is an explanatory diagram illustrating a method of producing a power module substrate and a power module substrate with a heat sink using the power module substrate according to other embodiment of the present invention.
FIG. 14 is an explanatory diagram illustrating film thickness measuring points in Examples.

### DETAILED DESCRIPTION OF THE INVENTION

Hereinafter, a power module substrate, a power module substrate with a heat sink, and a power module according to an embodiment of the present invention is described with reference to the attached drawings. A ceramic substrate described in the following embodiment of the present invention is a ceramic substrate made of Al₂O₃.

### (First Embodiment)

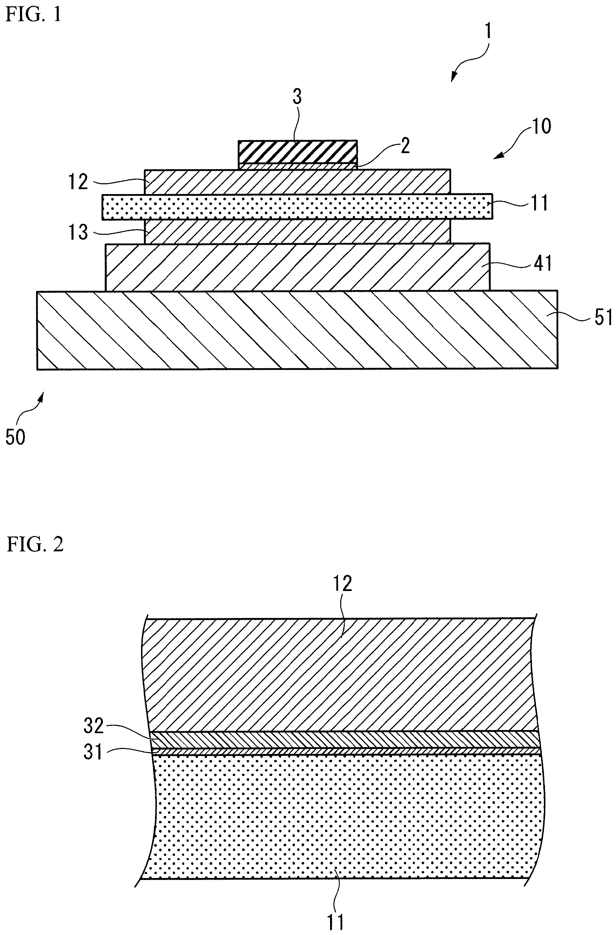

First, the first embodiment is described. FIG. 1 shows a power module substrate 50 with a heat sink using a power module substrate 10 and a power module 1 according to the embodiment.

The power module 1 includes the power module substrate 10 on which a circuit layer 12 is arranged, a semiconductor element 3 (electronic component) bonded onto the surface of the circuit layer 12 through a solder layer 2, a buffering plate 41, and a heat sink 51. Here, the solder layer 2 is formed of, for example, a Sn-Ag-based, Sn-In-based, or Sn-Ag-Cu-based solder material. In the embodiment, a Ni-plated layer (not shown) is provided between the circuit layer 12 and the solder layer 2.

The power module substrate 10 includes the ceramic substrate 11, the circuit layer 12 arranged on one surface (which is a first surface and an upper surface in FIG. 1) of the ceramic substrate 11, and a metal layer 13 arranged on the other surface (which is a second surface and a lower surface in FIG. 1) of the ceramic substrate 11.

The ceramic substrate 11 prevents electrical connection between the circuit layer 12 and the metal layer 13 and is composed of Al₂O₃ (alumina) having a high degree of insulation. In addition, the thickness of the ceramic substrate 11 is set to the range from 0.2 mm to 1.5 mm and is set to 0.635 mm in the embodiment.

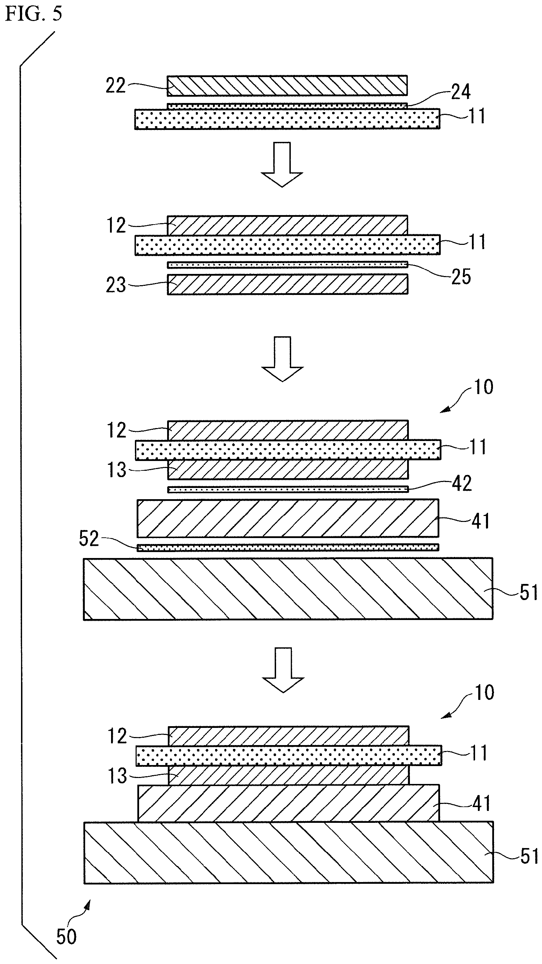

As shown in FIG. 5, the circuit layer 12 is formed by bonding a copper sheet 22 onto the first surface (the upper surface in FIG. 5) of the ceramic substrate 11. The thickness of the circuit layer 12 is set to the range of 0.1 mm or more and 1.0 mm or less, and is set to 0.3 mm in the embodiment. In addition, a circuit pattern is formed in the circuit layer 12, and one surface (the upper surface in FIG. 1) is set as the mounting surface on which the semiconductor element 3 is mounted. The other surface of the circuit layer 12 (the lower surface in FIG. 1) is bonded onto the first surface of the ceramic substrate 11.

In the embodiment, the copper sheet 22 (circuit layer 12) is formed of a rolled plate of oxygen-free copper (OFC) having purity of 99.99% by mass or more. The copper sheet may be a rolled plate of a copper alloy.

Here, a paste for copper sheet bonding containing Ag and an oxide-forming element, which will be described later, is used to bond the ceramic substrate 11 and the circuit layer 12.

As shown in FIG. 5, the metal layer 13 is formed by bonding an aluminum sheet 23 onto the second surface of the ceramic substrate 11 (the lower surface in FIG. 5). The thickness of the metal layer 13 is set to the range of 0.6 mm or more and 6.0 mm or less, and is set to 0.6 mm in the embodiment.

In the embodiment, the aluminum sheet 23 (metal plate 13) is formed of a rolled plate of aluminum (so-called 4N aluminum) having purity of 99.99% by mass or more.

The buffering plate 41 absorbs strain caused by a thermal cycle and as shown in FIG. 1, is formed on the other surface of the metal layer 13 (the lower surface in FIG. 1). One surface of the metal layer is bonded onto the second surface of the ceramic substrate 11. The thickness of the buffering plate 41 is set to the range of 0.5 mm or more and 7.0 mm or less, and is set to 0.9 mm in the embodiment.

In the embodiment, the buffering plate 41 is formed of a rolled plate of aluminum (so-called 4N aluminum) having purity of 99.99% by mass or more.

The heat sink 51 is for dissipating heat from the above-described power module substrate 10. The heat sink 51 in the embodiment is bonded to the power module substrate 10 through the buffering plate 41.

In the embodiment, the heat sink 51 is composed of aluminum and an aluminum alloy. Specifically, the heat sink is formed of a rolled plate of an A6063 alloy. Further, the thickness of the heat sink 51 is set to the range of 1 mm or more and 10 mm or less and is set to 5 mm in the embodiment.

FIG. 2 is an enlarged diagram of the bonding interface between the ceramic substrate 11 and the circuit layer 12. On the surface of the ceramic substrate 11, an oxide layer 31 formed of the oxide of the oxide-forming element contained in the paste for copper sheet bonding is formed.

Then, an Ag-Cu eutectic structure layer 32 is formed to be laminated on the oxide layer 31. Here, the thickness of the Ag-Cu eutectic structure layer 32 is set to 15 µm or less.

Next, a method of producing the power module substrate 10 having the above-described configuration and a method of producing the power module substrate 50 with a heat sink is described.

As described above, the paste for copper sheet bonding containing Ag and an oxide-forming element is used to bond the ceramic substrate 11 and the copper sheet 22 serving as the circuit layer 12. First, the paste for copper sheet bonding is described.

The paste for copper sheet bonding contains a powder component including Ag and an oxide-forming element, a resin, a solvent, a dispersing agent, a plasticizer, and a reducing agent.

Here, the content of the powder component is set to 40% by mass or more and 90% by mass or less with respect to the total amount of the paste for copper sheet bonding.

In addition, in the embodiment, the viscosity of the paste for copper sheet bonding is adjusted to 10 Pa·s or more and 500 Pa·s or less and more preferably to 50 Pa·s or more and 300 Pa·s or less.

The oxide-forming element is one or more elements selected from Ti, Hf, Zr, and Nb and the powder component contains Ti as the oxide-forming element in the embodiment.

Here, it is preferable that as the composition of the powder component, the content of the oxide-forming element (Ti in the embodiment) is set to 0.4% by mass or more and 75% by mass or less and a balance includes Ag and inevitable impurities to apply the paste in an appropriate thickness. In the embodiment, 10% by mass of Ti is contained and the balance includes Ag and inevitable impurities.

In addition, in the embodiment, as the powder component including Ag and an oxide-forming element (Ti), an alloy powder of Ag and Ti is used. The alloy powder is prepared by the atomizing method and the prepared alloy powder is sieved so as to set the particle size preferably to 40 µm or less, more preferably to 20 µm or less, and even more preferably to 10 µm or less.

The particle size of the alloy powder can be measured by, for example, using the microtrack method.

The resin is used for adjusting the viscosity of the paste for copper sheet bonding and for example, ethyl cellulose, methyl cellulose, polymethyl methacrylate, acrylic resin, alkyd resin, and the like can be used.

The solvent is a solvent for the powder component and for example, methyl cellosolve, ethyl cellosolve, terpineol, toluene, texanol, triethyl citrate, and the like can be used.

The dispersing agent is used for uniformly dispersing the powder component and, for example, an anionic surfactant, a cationic surfactant, and the like can be used.

The plasticizer is used for improving the formability of the paste for copper sheet bonding and for example, dibutyl phthalate, dibutyl adipate, and the like can be used.

The reducing agent is used for removing an oxide film or the like formed on the surface of the powder component and for example, rosin, abietic acid, and the like can be used. In the embodiment, abietic acid is used.

The dispersing agent, plasticizer, and reducing agent may be added as required and the paste for copper sheet bonding may be formed without adding the dispersing agent, the plasticizer, and the reducing agent.

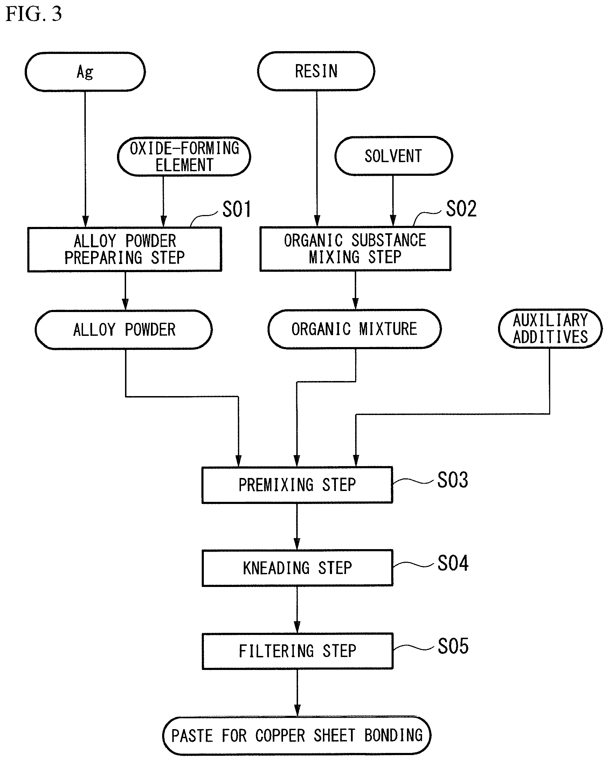

Here, a method of producing the paste for copper sheet bonding is described with reference to the flow chart shown in FIG. 3.

First, as described above, an alloy powder containing Ag and an oxide-forming element (Ti) is prepared by the atomizing method and the prepared alloy powder is sieved to obtain an alloy powder having a particle size of 40 µm or less (alloy powder preparing step S01).

In addition, the solvent and the resin are mixed to form an organic mixture (organic substance mixing step S02).

Then, the alloy powder obtained in the alloy powder preparing step S01 and the organic mixture obtained in the organic substance mixing step S02 are premixed with auxiliary additives such as a dispersing agent, a plasticizer, and a reducing agent using a mixer (premixing step S03).

Next, the premixture is mixed while being kneaded using a roll mill having plural rolls (kneading step S04).

The mixture obtained in the kneading step S04 is filtered by a paste filter (filtering step S05).

In this manner, the above-described paste for copper sheet bonding is produced.

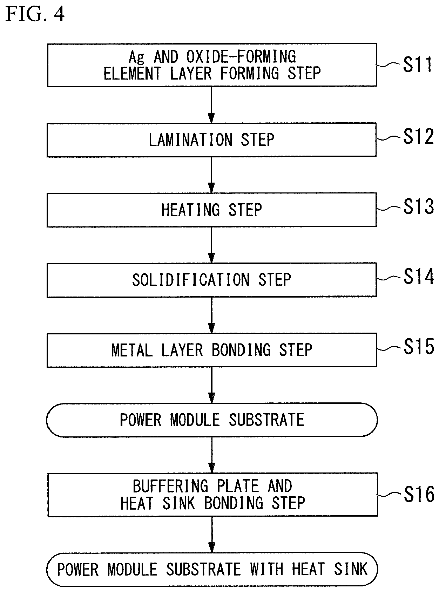

Next, the method of producing the power module substrate 10 according to the embodiment using the paste for copper sheet bonding, and the method of producing the power module substrate 50 with a heat sink is described with reference to FIGS. 4 to 6.

### (Ag and Oxide-forming element Layer Forming Step S11)

First, as shown in FIG. 5, the above-described paste for copper sheet bonding is applied onto one surface of the ceramic substrate 11 by screen printing and dried to form an Ag and oxide-forming element layer 24. The thickness of the Ag and oxide-forming element layer 24 after drying is set to 60 µm or more and 300 µm or less.

### (Lamination Step S12)

Next, the copper sheet 22 is laminated on the first surface of the ceramic substrate 11. That is, the Ag and oxide-forming element layer 24 is interposed between the ceramic substrate 11 and the copper sheet 22.

### (Heating Step S13)

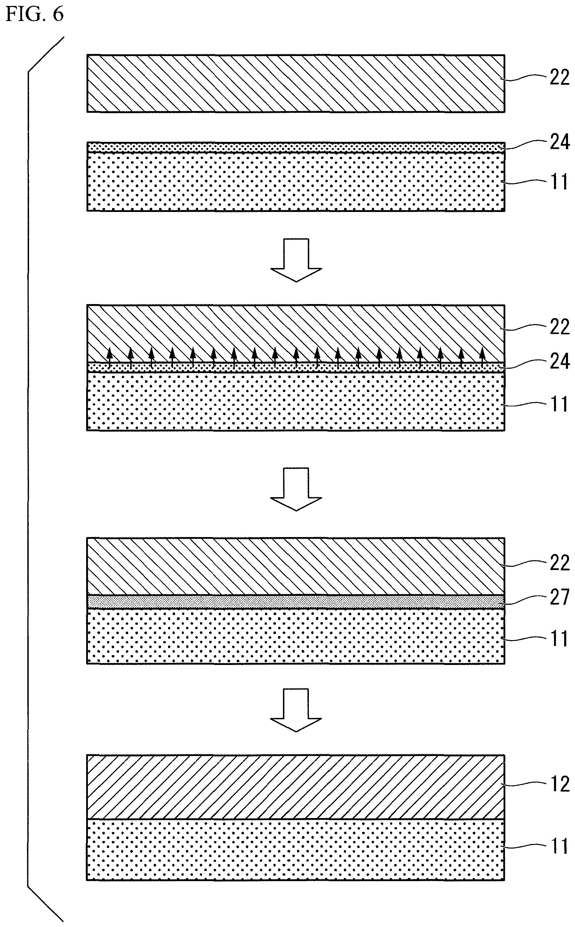

Next, the copper sheet 22 and the ceramic substrate 11 are put into a vacuum heating furnace and are heated therein in a state in which the copper sheet and the ceramic substrate are compressed in a lamination direction (at a pressure of 0.1 MPa (1 kgf/cm²) to 3.4 MPa (35 kgf/cm²)). Then, as shown in FIG. 6, Ag in the Ag and oxide-forming element layer 24 diffuses toward the copper sheet 22. At this time, part of the copper sheet 22 is melted by reaction of Cu with Ag and a molten metal region 27 is formed at the interface between the copper sheet 22 and the ceramic substrate 11.

Here, in the embodiment, the pressure inside the vacuum heating furnace is set to the range of 10⁻⁶ Pa or more and 10⁻³ Pa or less, and the heating temperature is set to the range of 790°C or higher and 850°C or lower.

### (Solidification Step S14)

Next, the ceramic substrate 11 and the copper sheet 22 are bonded by solidifying the molten metal region 27. After the solidification step S14 ends, Ag in the Ag and oxide-forming element layer 24 sufficiently diffuses and the Ag and oxide-forming element layer 24 does not remain at the bonding interface between the ceramic substrate 11 and the copper sheet 22. The molten metal region 27 is solidified by cooling such as natural cooling after the heating in the vacuum heating furnace is stopped.

### (Metal Layer Bonding Step S15)

Next, the aluminum sheet 23 serving as the metal layer 13 is bonded onto the second surface of the ceramic substrate 11. In the embodiment, as shown in FIG. 5, the aluminum sheet 23 serving as the metal layer 13 is laminated on the second surface of the ceramic substrate 11 through a brazing material foil 25 having a thickness of 5 µm to 50 µm (14 µm in the embodiment). In the embodiment, the brazing material foil 25 is formed of an Al-Si-based brazing material containing Si which is a melting point lowering element.

Next, the ceramic substrate 11 and the aluminum sheet 23 are put into the heating furnace and are heated therein in a state in which the ceramic substrate and the aluminum sheet are compressed in a lamination direction (at a pressure of 0.1 MPa (1 kgf/cm²) to 3.4 MPa (35 kgf/cm²)). Then, a part of the brazing material foil 25 and the aluminum sheet 23 is melted to form a molten metal region at the interface between the aluminum sheet 23 and the ceramic substrate 11. Here, the heating temperature is 550°C or higher and 650°C or lower and the heating time is 30 minutes or more and 180 minutes or less.

Next, the molten metal region formed at the interface between the aluminum sheet 23 and the ceramic substrate 11 is solidified and thus the ceramic substrate 11 and the aluminum sheet 23 are bonded.

In this manner, the power module substrate 10 according to the embodiment is produced.

### (Buffering Plate and Heat Sink Bonding Step S16)

Next, as shown in FIG. 5, the buffering plate 41 and the heat sink 51 are laminated on the other surface of the metal layer 13 of the power module substrate 10 (the lower side in FIG. 5) through brazing material foils 42 and 52, respectively. That is, the buffering plate 41 is laminated on the other surface of the metal layer 13 through the brazing material foil 42 in such a manner that one surface of the buffering plate 41 (the upper side in FIG. 5) faces the other surface of the metal layer 13 and further the heat sink 51 is laminated on the other surface of the buffering plate 41 (the lower side in FIG. 5) through the brazing material foil 52.

In the embodiment, the thickness of the brazing material foils 42 and 52 is set to 5 µm to 50 µm (14 µm in the embodiment) and the Al-Si-based brazing material containing Si which is a melting point lowering element is used as the brazing material foils 42 and 52.

Next, the power module substrate 10, the buffering plate 41, and the heat sink 51 are put into the heating furnace and are heated therein in a state in which the power module substrate, the buffering plate, and the heat sink are compressed in a lamination direction (at a pressure of 0.1 MPa (1 kgf/cm²) to 3.4 MPa (35 kgf/cm²)). Then, the molten metal regions are formed at the interface between the metal layer 13 and the buffering plate 41 and the interface between the buffering plate 41 and the heat sink 51. Here, the heating temperature is 550°C or higher and 650°C or lower and the heating time is 30 minutes or more and 180 minutes or less.

Next, the molten metal regions respectively formed at the interface between the metal layer 13 and the buffering plate 41 and the interface between the buffering plate 41 and the heat sink 51 are solidified to bond the power module substrate 10, the buffering plate 41, and the heat sink 51.

In this manner, the power module substrate 50 with a heat sink according to the embodiment is produced.

Then, the semiconductor element 3 is mounted on the surface of the circuit layer 12 through a solder material and is subjected to solder bonding in a reducing furnace.

Thus, the power module 1 in which the semiconductor element 3 is bonded onto the circuit layer 12 through the solder layer 2 is produced.

According to the thus-configured power module substrate 10 of the embodiment, at a portion in which the circuit layer 12 formed of the copper sheet 22 and the ceramic substrate 11 are bonded, the thickness of the Ag-Cu eutectic structure layer 32 is set to 15 µm or less, and thus, even when shear stress caused by a difference in thermal expansion coefficient between the ceramic substrate 11 and the circuit layer 12 is applied during loading of a thermal cycle, the circuit layer 12 is appropriately deformed, whereby cracking in the ceramic substrate 11 can be suppressed.

In addition, since the oxide layer 31 is formed on the surface of the ceramic substrate 11, the ceramic substrate 11 and the circuit layer 12 can be reliably bonded.

Further, since the ceramic substrate 11 is formed of Al₂O₃ in the embodiment, the oxide-forming element contained in the paste for copper sheet bonding reacts with the ceramic substrate 11 to form the oxide layer 31 on the surface of the ceramic substrate 11. Thus, the ceramic substrate 11 and the oxide layer 31 can be firmly joined.

Furthermore, the oxide layer 31 contains one or more elements selected from Ti, Hf, Zr, and Nb. In the embodiment, specifically, since the oxide layer 31 contains TiO₂, the ceramic substrate 11 and the oxide layer 31 are firmly joined. Thus, the ceramic substrate 11 and the circuit layer 12 can be firmly bonded to each other.

In the power module substrate 50 with a heat sink and the power module 1 according to the embodiment, heat generated in the power module substrate 10 can be dissipated by the heat sink 51. In addition, since the circuit layer 12 and the ceramic substrate 11 can be reliably bonded, heat generated from the semiconductor element 3 mounted on the mounting surface of the circuit layer 12 can be reliably transferred to the heat sink 51 and the temperature rise in the semiconductor element 3 can be suppressed. Therefore, even when the power density (the amount of heat generation) of the semiconductor element 3 is improved, it is possible to sufficiently cope with this situation.

Further, in the power module substrate 50 with a heat sink and the power module 1 according to the embodiment, the buffering plate 41 is arranged between the power module substrate 10 and the heat sink 51 and thus the strain caused by a difference in thermal expansion coefficient between the power module substrate 10 and the heat sink 51 can be absorbed by deformation of the buffering plate 41.

In addition, in the embodiment, the production method includes the Ag and oxide-forming element layer forming step S11, the lamination step S12, the heating step S13, and the solidifying step S14. In the Ag and oxide-forming element layer forming step S11, the Ag and oxide-forming element layer 24 containing Ag and an oxide-forming element is formed on the bonding surface of the ceramic substrate 11. In the lamination step S12, the ceramic substrate 11 and the copper sheet 22 are laminated through the Ag and oxide-forming element layer 24. In the heating step S13, the laminated ceramic substrate 11 and copper sheet 22 are heated while the ceramic substrate and the copper sheet are compressed in the lamination direction, and then the molten metal region 27 is formed at the interface between the ceramic substrate 11 and the copper sheet 22. In the solidification step S14, the molten metal region 27 is solidified to bond the ceramic substrate 11 and the copper sheet 22. In the heating step S13, since the molten metal region 27 is formed at the interface between the ceramic substrate 11 and the copper sheet 22 by allowing Ag to diffuse toward the copper sheet 22, the thickness of the molten metal region 27 can be kept thin, and the thickness of the Ag-Cu eutectic structure layer 32 can be set to 15 µm or less. Further, in the heating step S13, the oxide layer 31 is formed on the surface of the ceramic substrate 11 and thus the ceramic substrate 11 and the copper sheet 22 can be firmly bonded.

Further, in the embodiment, since the paste for copper sheet bonding containing Ag and an oxide-forming element is applied in the Ag and oxide-forming element layer forming step S11, it is possible to form the Ag and oxide-forming element layer 24 on the bonding surface of the ceramic substrate 11.

In the paste for copper sheet bonding used in the embodiment, as the composition of the powder component, the content of the oxide-forming element is set to 0.4% by mass or more and 75% by mass or less, and the balance includes Ag and inevitable impurities. Thus, the oxide layer 31 can be formed on the surface of the ceramic substrate 11. In this manner, since the ceramic substrate 11 and the circuit layer 12 formed of the copper sheet 22 are bonded to each other through the oxide layer 31, the bonding strength between the ceramic substrate 11 and the circuit layer 12 can be improved.

In addition, in the embodiment, since the particle size of the powder constituting the powder component, that is, the alloy powder containing Ag and an oxide-forming element (Ti) is set to 40 µm or less, it is possible to apply the paste for copper sheet bonding onto the substrate thinly. Thus, the thickness of the Ag-Cu eutectic structure layer 32 to be formed after bonding (after solidification) can be reduced.

Further, since the content of the powder component is set to 40% by mass or more and 90% by mass or less, Ag diffuses toward the copper sheet 22 to reliably form the molten metal region 27 and thus the copper sheet 22 and the ceramic substrate 11 can be bonded. In addition, due to the content of the above-described powder component, the room for the content of the solvent is secured and the paste for copper sheet bonding can be reliably applied onto the bonding surface of the ceramic substrate 11. Thus, the Ag and oxide-forming element layer 24 can be reliably formed.

In the embodiment, since the paste for copper sheet bonding contains a dispersing agent as required, the powder component can be dispersed and thus Ag can diffuse uniformly. In addition, a uniform oxide layer 31 can be formed.

In addition, in the embodiment, since the paste for copper sheet bonding contains a plasticizer as required, the shape of the paste for copper sheet bonding can be relatively freely formed and thus the paste can be reliably applied onto the bonding surface of the ceramic substrate 11.

Further, in the embodiment, since the paste for copper sheet bonding contains a reducing agent as required, due to the action of the reducing agent, an oxide film or the like formed on the surface of the powder component can be removed. Thus, Ag can reliably diffuse and the oxide layer 31 can be reliably formed.

### (Second Embodiment)

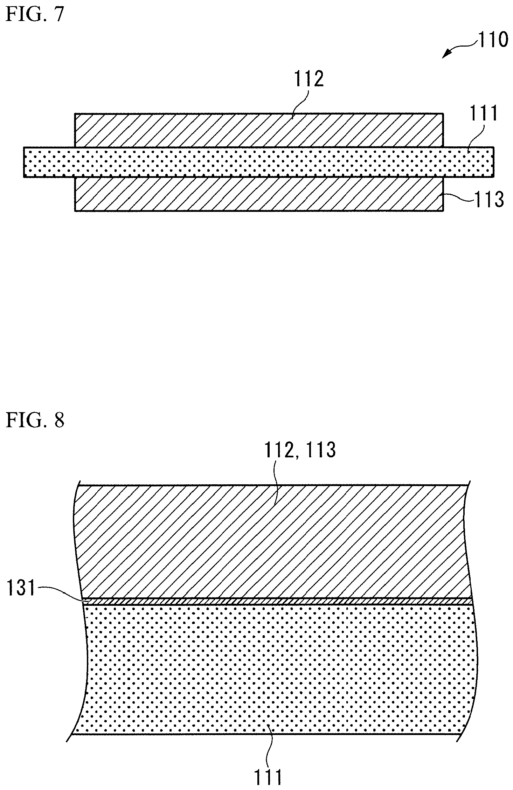

Next, the second embodiment is described. FIG. 7 shows a power module substrate 110 according to the embodiment.

The power module substrate 110 includes a ceramic substrate 111, a circuit layer 112 arranged on one surface (which is a first surface and an upper surface in FIG. 7) of the ceramic substrate 111, and a metal layer 113 arranged on the other surface (which is a second surface and a lower surface in FIG. 7) of the ceramic substrate 111.

The ceramic substrate 111 prevents electrical connection between the circuit layer 112 and the metal layer 113 and is composed of Al₂O₃ (alumina) having a high degree of insulation. In addition, the thickness of the ceramic substrate 111 is set to the range from 0.2 mm to 1.5 mm and is set to 0.32 mm in the embodiment.

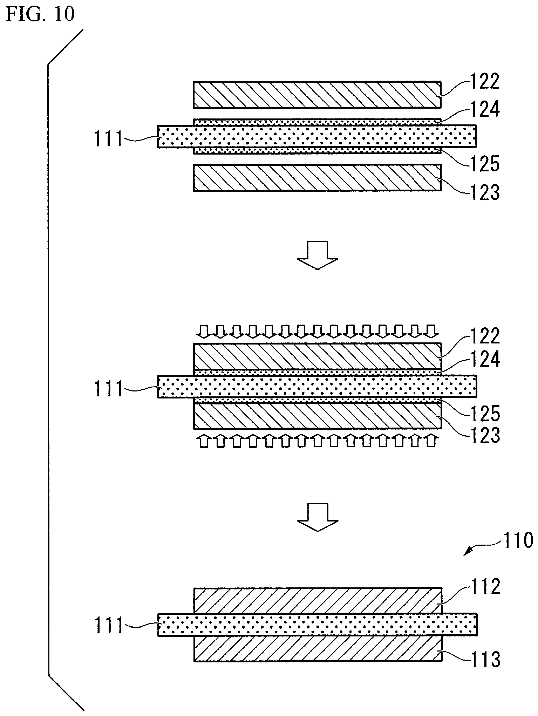

As shown in FIG. 10, the circuit layer 112 is formed by bonding a copper sheet 122 onto the first surface (the upper surface in FIG. 10) of the ceramic substrate 111. The thickness of the circuit layer 112 is set to the range of 0.1 mm or more and 1.0 mm or less, and is set to 0.6 mm in the embodiment. In addition, a circuit pattern is formed in the circuit layer 112, and one surface (the upper surface in FIG. 7) is set as the mounting surface on which a semiconductor element is mounted. The other surface of the circuit layer 112 (the lower surface in FIG. 7) is bonded onto the first surface of the ceramic substrate 111.

In the embodiment, the copper sheet 122 (circuit layer 112) is formed of a rolled plate of oxygen-free copper (OFC) having purity of 99.99% by mass or more.

As shown in FIG. 10, the metal layer 113 is formed by bonding a copper sheet 123 on the second surface of the ceramic substrate 111 (the lower surface in FIG. 10). The thickness of the metal layer 113 is set to the range of 0.1 mm or more and 1.0 mm or les, and is set to 0.6 mm in the embodiment.

In the embodiment, the copper sheet 123 (metal plate 113) is formed of a rolled plate of oxygen-free copper (OFC) having purity of 99.99% by mass or more.

Here, a paste for copper sheet bonding containing Ag and an oxide-forming element, which is described later, is used to bond the ceramic substrate 111 and the circuit layer 112 and to bond the ceramic substrate 111 and the metal layer 113.

FIG. 8 is an enlarged diagram showing the bonding interface between the ceramic substrate 111 and the circuit layer 112 or the metal layer 113. On the surface of the ceramic substrate 111, an oxide layer 131 formed of the oxide of the oxide-forming element contained in the paste for copper sheet bonding is formed.

Next, a method of producing the power module substrate 110 having the above-described configuration is described.

As described above, a paste for copper sheet bonding containing Ag and an oxide-forming element is used to bond the ceramic substrate 111 and the copper sheet 122 serving as the circuit layer 112. Here, first, the paste for copper sheet bonding is described.

The paste for copper sheet bonding used in the embodiment contains a powder component including Ag and an oxide-forming element, a resin, a solvent, a dispersing agent, a plasticizer, and a reducing agent.

The powder component contains one or more additive elements elected from In, Sn, Al, Mn, and Zn in addition to Ag and the oxide-forming element and contains Sn in the embodiment.

Here, the content of the powder component is set to 40% by mass or more and 90% by mass or less with respect to the total amount of the paste for copper sheet bonding.

Further, in the embodiment, the viscosity of the paste for copper sheet bonding is adjusted to 10 Pa·s or more and 500 Pa·s or less, and more preferably to 50 Pa·s or more and 300 Pa·s or less.

The oxide-forming element is one or more elements selected from Ti, Hf, Zr, and Nb and the powder component contains Zr as the oxide-forming element in the embodiment.

Here, as the composition of the powder component, the content of the oxide-forming element (Zr in the embodiment) is set to 0.4% by mass or more and 75% by mass or less, the content of one or more additive elements selected from In, Sn, Al, Mn, and Zn (Sn in the embodiment) is set to 0% by mass or more and 50% by mass or less, and the balance includes Ag and inevitable impurities. However, the content of Ag is 25% by mass or more. In the embodiment, the powder component contains 40% by mass of Zr and 20% by mass of Sn, and the balance includes Ag and inevitable impurities.

In the embodiment, as the powder component, element powders (Ag powder, Zr powder, and Sn powder) are used. These Ag powder, Zr powder, and Sn powder are blended so that the total powder component has the above-described composition.

The particle diameter of each of these Ag powder, Zr powder, and Sn powder is set to 40 µm or less, preferably 20 µm or less, and more preferably 10 µm or less.

For example, the particle diameter of each of these Ag powder, Zr powder, and Sn powder can be measured by using a microtrack method.

Here, the same resin and the solvent as those in the first embodiment are used. In addition, in the embodiment, a dispersing agent, a plasticizer, and a reducing agent are added as required.

Further, the paste for copper sheet bonding used in the embodiment is produced according to the production method shown in the first embodiment. That is, the paste is produced in the same manner as in the first embodiment except that the Ag powder, the Zr powder, and the Sn powder are used instead of the alloy powder.

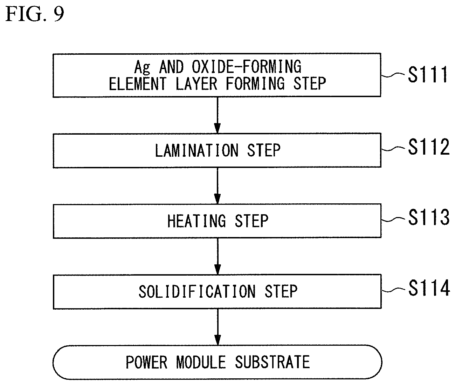

Next, a method of producing the power module substrate 110 using the paste for copper sheet bonding is described with reference to FIGS. 9 and 10.

### (Ag and Oxide-forming element Layer Forming Step S111)

First, as shown in FIG. 10, the paste for copper sheet bonding according to the above-described embodiment is applied to the first surface and the second surface of the ceramic substrate 111 by screen printing to form Ag and oxide-forming element layers 124 and 125. The thickness of the Ag and oxide-forming element layers 124 and 125 after drying is 60 µm or more and 300 µm or less.

### (Lamination Step S112)

Next, the copper sheet 122 is laminated on the first surface of the ceramic substrate 111. In addition, the copper sheet 123 is laminated on the second surface of the ceramic substrate 111. That is, the Ag and oxide-forming element layers 124 and 125 are interposed between the ceramic substrate 111 and the copper sheet 122 and between the ceramic substrate 111 and the copper sheet 123.

### (Heating Step S113)

Next, the copper sheet 122, the ceramic substrate 111, and the copper sheet 123 are put into a vacuum heating furnace and are heated therein in a state in which the copper sheets and the ceramic substrate are compressed in a lamination direction (at a pressure of 0.1 MPa (1 kgf/cm²) to 3.4 MPa (35 kgf/cm²)). Then, Ag in the Ag and oxide-forming element layer 124 diffuses toward the copper sheet 122 and also Ag in the Ag and oxide-forming element layer 125 diffuses toward the copper sheet 123.

At this time, the copper sheet is melted by reaction of Cu in the copper sheet 122 with Ag and thus a molten metal region is formed at the interface between the copper sheet 122 and the ceramic substrate 111. In addition, the copper sheet is melted by reaction of Cu in the copper sheet 123 with Ag and thus a molten metal region is formed at the interface between the copper sheet 123 and the ceramic substrate 111.

Here, in the embodiment, the pressure in the vacuum heating furnace is set to the range of 10⁻⁶ Pa or more and 10⁻³ Pa or less and the heating temperature is set to the range of 790°C or higher and 850°C or less.

### (Solidification Step S114)

Next, the ceramic substrate 111 and the copper sheets 122 and 123 are bonded by solidifying the molten metal regions. After the solidification step S114 ends, Ag in the Ag and oxide-forming element layers 124 and 125 sufficiently diffuses and the Ag and oxide-forming element layers 124 and 125 do not remain at the bonding interfaces among the ceramic substrate 111 and the copper sheets 122 and 123. The molten metal regions are solidified by cooling such as natural cooling after the heating in the vacuum heating furnace is stopped.

In this manner, the power module substrate 110 according to the embodiment is produced.

In the power module substrate 110, a semiconductor element is mounted on the circuit layer 112 and also a heat sink is arranged on the other side of the metal layer 113.

In the power module substrate 110 having the above-described configuration according to the embodiment, the thickness of the Ag-Cu eutectic structure layer is set to 15 µm or less at the portion in which the circuit layer 112 formed of the copper sheet 122 and the ceramic substrate 111 are bonded, and in the embodiment, the Ag-Cu eutectic structure layer is too thin to be apparently observed. Therefore, even when shear stress caused by a difference in thermal expansion coefficient between the ceramic substrate 111 and the circuit layer 112 during loading of a thermal cycle, the circuit layer 112 is appropriately deformed. Therefore, it is possible to suppress occurrence of cracking in the ceramic substrate 111.

In addition, since the oxide layer 131 is formed on the surface of the ceramic substrate 111, the ceramic substrate 111 and the circuit layer 112 can be reliably bonded.

Further, since the molten metal regions are formed by diffusion of Ag toward the copper sheets 122 and 123, at the portion in which the ceramic substrate 111 and the copper sheets 122 and 123 are bonded, the molten metal regions are not formed more than necessary and the thickness of the Ag-Cu eutectic structure layer to be formed after bonding (solidification) is reduced. Thus, it is possible to suppress occurrence of cracking in the ceramic substrate 111.

In addition, since the powder component contains Zr as the oxide-forming element in the embodiment, the ceramic substrate 111 formed of Al₂O₃ reacts with Zr to form the oxide layer 131. Thus, the ceramic substrate 111 and the copper sheets 122 and 123 can be reliably bonded.

Then, in the embodiment, since the powder component contains one or more additive elements selected from In, Sn, Al, Mn, and Zn (Sn in the embodiment) in addition to Ag and the oxide-forming element (Zr in the embodiment), the molten metal region can be formed at a lower temperature and the thickness of the Ag-Cu eutectic structure layer to be formed can be reduced.

In the above description, the embodiments of the present invention have been described.

For example, the powder component using Ti and Zr as the oxide-forming elements has been described. However, there is no limitation thereto and Hf and Nb may be used as the oxide-forming elements.

In addition, the powder component included in the paste for copper sheet bonding (Ag and an oxide-forming element-containing paste) may include hydrides of oxide-forming elements such as TiH₂ and ZrH₂. In this case, since hydrogen in the hydrides of the oxide-forming elements functions as a reducing agent, an oxide film or the like formed on the surface of the copper sheet can be removed. Thus, Ag can reliably diffuse and an oxide layer can be reliably formed.

Further, the powder component using Sn as the additive element has been described in the second embodiment. However, there is no limitation thereto and one or more additive elements selected from In, Sn, Al, Mn, and Zn may be used.

The powder constituting the powder component having a particle size of 40 µm or less has been described. However, there is no limitation thereto and the particle size is not limited.

Further, the paste including a dispersing agent, a plasticizer, and a reducing agent has been described. However, there is no limitation thereto and these agents may not be included therein. These dispersing agent, plasticizer, and reducing agent may be added as required.

Furthermore, the bonding of the aluminum sheet and the ceramic substrate or the bonding of the aluminum sheets by brazing has been described. However, there is no limitation thereto and a casting method, a metal paste method and the like may be used. In addition, the aluminum sheet and the ceramic substrate, the aluminum sheet and a top plate, or other aluminum materials may be bonded by arranging Cu, Si, Zn, Ge, Ag, Mg, Ca, Ga, and Li therebetween using a transient liquid phase bonding method.

The power module substrate and the power module substrate with a heat sink in the present invention are not limited to the power module substrate and the power module substrate with a heat sink produced by the production method shown in FIGS. 5, 6, and 10, and power module substrates and power module substrates with a heat sink produced by other production methods may be employed.

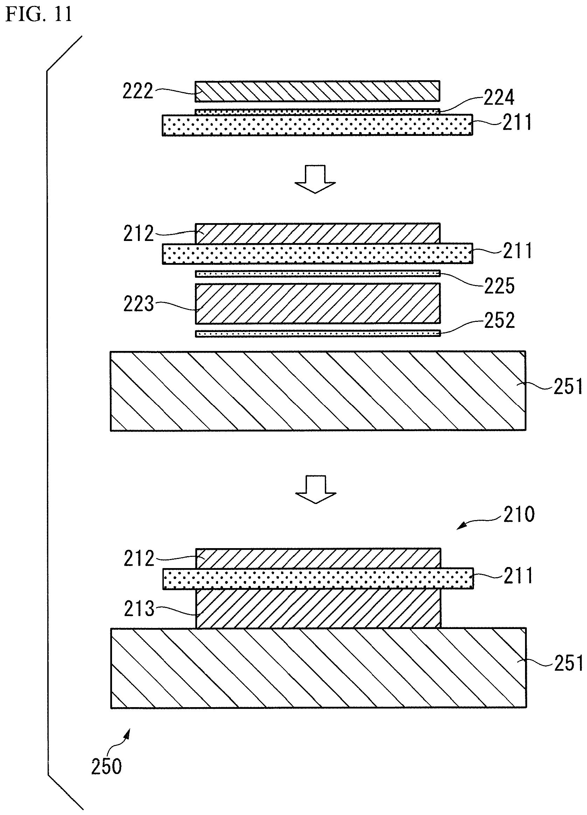

For example, as shown in FIG. 11, a copper sheet 222 serving as a circuit layer 212 may be bonded onto a first surface of a ceramic substrate 211 through an Ag and oxide-forming element layer 224, and an aluminum sheet 223 serving as a metal layer 213 may be bonded onto a second surface of the ceramic substrate 211 through a brazing material foil 225 (the second surface of the ceramic substrate 211 and one surface of the aluminum sheet 223 serving as the metal layer 213 are bonded though the brazing material foil 225) and also a heat sink 251 may be bonded onto the other surface of the aluminum sheet 223 through a brazing material foil 252. In this manner, a power module substrate 250 with a heat sink including a power module substrate 210 and the heat sink 251 is produced.

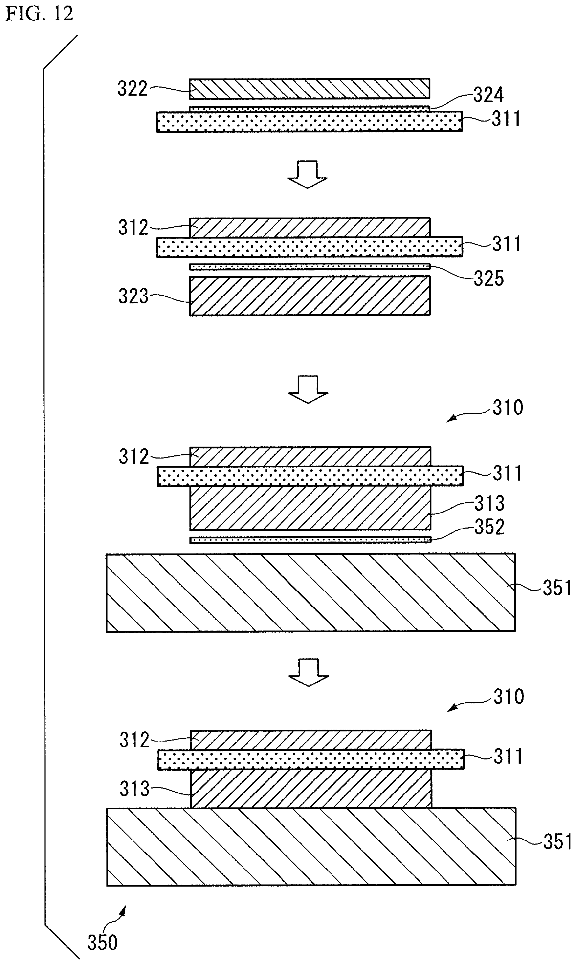

As shown in FIG. 12, a copper sheet 322 serving as a circuit layer 312 may be bonded onto a first surface of a ceramic substrate 311 through an Ag and oxide-forming element layer 324, and an aluminum sheet 323 serving as a metal layer 313 may be bonded onto a second surface of the ceramic substrate 311 through a brazing material foil 325 (the second surface of the ceramic substrate 311 and one surface of the aluminum sheet 323 serving as the metal layer 313 are bonded though the brazing material foil 325). In this manner, a power module substrate 310 is produced. Then, a heat sink 351 may be bonded onto the other surface of the metal layer 313 through a brazing material foil 352. In this manner, a power module substrate 350 with a heat sink including the power module substrate 310 and the heat sink 351 is produced.

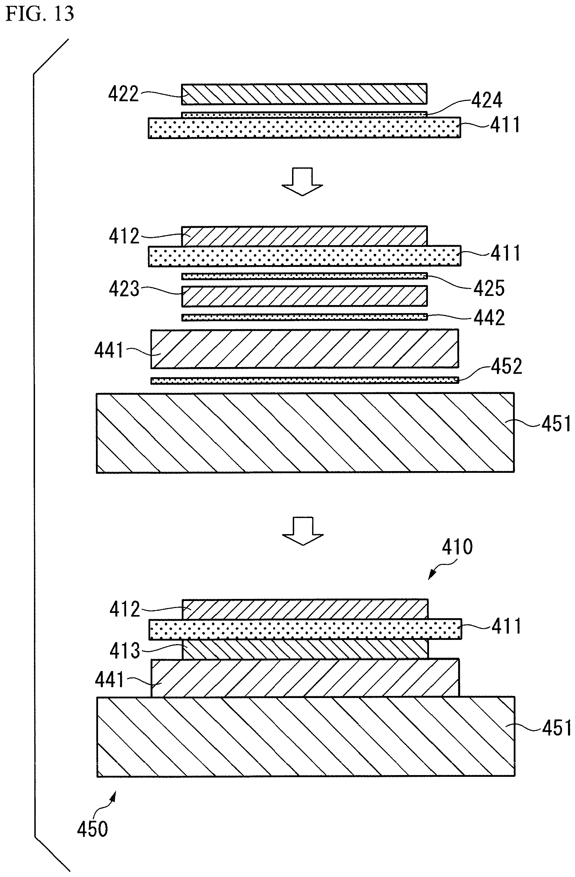

Further, as shown in FIG. 13, a copper sheet 422 serving as a circuit layer 412 may be bonded onto a first surface of a ceramic substrate 411 through Ag and oxide-forming element layer 424, an aluminum sheet 423 serving as a metal layer 413 may be bonded onto a second surface of the ceramic substrate 411 through a brazing material foil 425 (the second surface of the ceramic substrate 411 and one surface of the aluminum sheet 423 serving as the metal layer 413 are bonded through the brazing material foil 425) and also a buffering plate 441 may be bonded onto the other surface of the aluminum sheet 423 through a brazing material foil 442 (the other surface of the aluminum sheet 423 and one surface of the buffering plate 441 are bonded through the brazing material foil 442). A heat sink 451 may be bonded onto the other surface of the buffering plate 441 through a brazing material foil 452. In this manner, a power module substrate 450 with a heat sink including a power module substrate 410, the buffering plate 441, and the heat sink 451 is produced.

### [Examples]

Comparative experiments that were performed to confirm effectiveness of the present invention are explained below. Under the conditions shown in Tables 1, 2, and 3, various pastes were prepared. In Table 1, alloy powders were used as the powder component. In Table 2, powders of each element (element powders) were used as the powder component. In Table 3, powders of each element were used as the powder component and powders of hydrides of oxide-forming elements were used as the oxide-forming element. In Table 3, the contents of the oxide-forming elements (contents of active metals) were also shown in addition to the mixing ratio of element powders of hydrides of oxide-forming elements.

In addition, an anionic surfactant was used as the dispersing agent, dibutyl adipate was used as the plasticizer, and abietic acid was used as the reducing agent.

The mixing ratio of the resin, solvent, dispersing agent, plasticizer, and reducing agent other than the powder component was set to resin: solvent: dispersing agent: plasticizer: reducing agent = 7: 70: 3: 5: 15.

**[Table 1]**

| | | Alloy powder blending ratio/% by weight | | | | | | | | | | | Maximum particle size in alloy powder/µm | Powder component ratio in paste |
|---|---|---|---|---|---|---|---|---|---|---|---|---|---|---|
| | | Ag | Cu | Ti | Zr | Hf | Nb | In | Sn | Mn | Al | Zn | | |
| | 1 | 20 | | 80 | | | | | | | | | < 20 | 70% |
| | 2 | 40 | | 60 | | | | | | | | | < 20 | 60% |
| | 3 | 50 | | 50 | | | | | | | | | < 20 | 80% |
| | 4 | 60 | | 40 | | | | | | | | | < 40 | 40% |
| | 5 | 70 | | 30 | | | | | | | | | < 40 | 40% |
| | 6 | 80 | | 20 | | | | | | | | | < 40 | 80% |
| | 7 | 80 | | 5 | | | | 15 | | | | | < 10 | 50% |
| | 8 | 80 | | 5 | | | | | 15 | | | | < 10 | 50% |
| | 9 | 80 | | 5 | | | | | | | 15 | | < 10 | 70% |
| Example | 10 | 80 | | 5 | | | | | | 15 | | | < 40 | 80% |
| | 11 | 80 | | 15 | | | | | | 5 | | | < 40 | 80% |
| | 12 | 70 | | | 10 | | | 20 | | | | | < 30 | 70% |
| | 13 | 70 | | | 10 | | | | | | 20 | | < 30 | 40% |
| | 14 | 70 | | | 20 | | | | | | | 10 | < 30 | 90% |
| | 15 | 75 | | | | 10 | | | 15 | | | | < 5 | 50% |
| | 16 | 75 | | | | 20 | | | | | 5 | | < 5 | 50% |
| | 17 | 80 | | | | 5 | | | | | | 15 | < 5 | 90% |
| | 18 | 60 | | | | | 30 | 10 | | | | | < 20 | 80% |
| | 19 | 60 | | | | | 10 | | 30 | | | | < 20 | 80% |
| | 20 | 90 | | | | | 7 | | | | 3 | | < 20 | 60% |
| Comparative Example | 1 | 80 | | 20 | | | | | | | | | < 10 | 70% |
| | 2 | 70 | | 20 | | | | 10 | | | | | < 30 | 70% |
| Conventional Example | 1 | 70 | 28 | 2 | | | | | | | | | < 30 | 80% |

**[Table 2]**

| | | Element powder blending ratio/% by weight | | | | | | | | | | | Maximum particle size in whole element powder/µm | Powder component ratio in paste |
|---|---|---|---|---|---|---|---|---|---|---|---|---|---|---|
| | | Ag | Cu | Ti | Zr | Hf | Nb | In | Sn | Mn | Al | Zn | | |
| | 51 | 25 | | 75 | | | | | | | | | < 10 | 40% |
| | 52 | 30 | | 70 | | | | | | | | | < 10 | 40% |
| | 53 | 90 | | 10 | | | | | | | | | < 10 | 60% |
| | 54 | 95 | | 5 | | | | | | | | | < 10 | 70% |
| | 55 | 98 | | 2 | | | | | | | | | < 10 | 50% |
| | 56 | 99 | | 1 | | | | | | | | | < 10 | 40% |
| | 57 | 99.6 | | 0.4 | | | | | | | | | < 10 | 50% |
| | 58 | 70 | | 10 | | | | 20 | | | | | < 30 | 90% |
| | 59 | 70 | | 5 | | | | | | | | 25 | < 30 | 90% |
| Example | 60 | 70 | | 10 | | | | | | | | 20 | < 30 | 60% |
| | 61 | 60 | | | 40 | | | | | | | | < 5 | 60% |
| | 62 | 60 | | | 30 | | | | 10 | | | | < 5 | 50% |
| | 63 | 60 | | | 35 | | | | 5 | | | | < 5 | 60% |
| | 64 | 90 | | | | 3 | | 7 | | | | | < 40 | 90% |
| | 65 | 90 | | | | 4 | | | | 6 | | | < 40 | 50% |
| | 66 | 90 | | | | 8 | | | | | 2 | | < 40 | 70% |
| | 67 | 80 | | | | | 5 | | 15 | | | | < 20 | 50% |
| | 68 | 80 | | | | | 8 | | | | | 12 | < 20 | 50% |
| | 69 | 85 | | | | | 5 | | | 10 | | | < 20 | 50% |
| | 70 | 85 | | | | | 9 | | | | 6 | | < 20 | 40% |
| Comparative Example | 51 | 70 | | 30 | | | | | | | | | < 40 | 60% |
| | 52 | 70 | | 20 | | | | | | 10 | | | < 40 | 80% |
| Conventional Example | 51 | 70 | 28 | 2 | | | | | | | | | < 40 | 80% |

**[Table 3]**

| | | Element powder blending ratio/% by weight | | | | | | | | Content of active metal | | Maximum particle size in whole element powder/µm | Powder component ratio in paste |
|---|---|---|---|---|---|---|---|---|---|---|---|---|---|
| | | Ag | TiH₂ | ZrH₂ | In | Sn | Mn | Al | Zn | Ti | Zr | | |
| Example | 81 | 80 | 10 | | | | | | 10 | 9.6 | | < 15 | 80% |
| | 82 | 85 | 5 | | | | | 10 | | 4.8 | | < 10 | 75% |
| | 83 | 70 | 15 | | | | 15 | | | 14.4 | | < 5 | 70% |
| | 84 | 85 | | 15 | | | | | | | 14.8 | < 5 | 65% |
| | 85 | 70 | | 20 | | 10 | | | | | 19.7 | < 20 | 80% |
| | 86 | 75 | | 10 | 15 | | | | | | 9.8 | < 30 | 70% |

The power module substrate having the structure and produced by the production method shown in FIG. 10, power module substrates with a heat sink having the structure and produced by the production method shown in FIGS. 11 and 12, and power module substrates with a heat sink having the structure and produced by the production method shown in FIGS. 5 and 13 were prepared by bonding a ceramic substrate and a copper sheet using various pastes shown in Tables 1, 2, and 3.

In the power module substrate shown in FIG. 10, a copper sheet was bonded onto the first surface and the second surface of a ceramic substrate made of Al₂O₃ using the above-described various pastes. Therefore, a power module substrate in which the circuit layer and the metal layer were formed of a copper sheet was obtained. As the copper sheet, a rolled plate of oxygen-free copper was used.

In the power module substrates with a heat sink shown in FIGS. 11 and 12, a copper sheet was bonded onto the first surface of a ceramic substrate made of Al₂O₃ using the above-described various pastes to form a circuit layer.

In addition, an aluminum sheet was bonded onto the second surface of the ceramic substrate made of Al₂O₃ through a brazing material to form a metal layer. That is, the second surface of the ceramic substrate and one surface of the metal layer were bonded to each other through a brazing material. A plate of 4N aluminum having purity of 99.99% by mass or more was used as the aluminum sheet, and a brazing material foil formed of an Al-7.5% by mass Si alloy and having a thickness of 20 µm was used for the brazing material.

Further, as the heat sink, an aluminum sheet formed of A6063 was bonded onto the other surface of the metal layer of the power module substrate through a brazing material. As the brazing material, a brazing material foil formed of an Al-7.5% by mass Si alloy and having a thickness of 70 µm was used.

In the power module substrates with a heat sink shown in FIGS. 5 and 13, a copper sheet was bonded onto the first surface of a ceramic substrate made of Al₂O₃ using the above-described various pastes to form a circuit layer.

In addition, an aluminum sheet was bonded onto the second surface of a ceramic substrate made of Al₂O₃ through a brazing material to form a metal layer. That is, the second surface of the ceramic substrate and one surface of the metal layer were bonded though a brazing material. A plate of 4N aluminum having purity of 99.99% by mass or more was used as the aluminum sheet, and a brazing material foil formed of an Al-7.5% by mass Si alloy and having a thickness of 14 µm was used for the brazing material.

Further, an aluminum sheet formed of 4N aluminum as a buffering plate was bonded onto the other surface of the metal layer through a brazing material. That is, the other surface of the metal layer and one surface of the buffering plate were bonded to each other through the brazing material. As the brazing material, a brazing material foil formed of an Al-7.5% by mass Si alloy and having a thickness of 100 µm was used.

Further, an aluminum sheet formed of A6063 as a heat sink was bonded onto the other surface of the buffering plate of the metal layer through a brazing material. As the brazing material, a brazing material foil formed of an Al-7.5% by mass Si alloy and having a thickness of 100 µm was used.

The ceramic substrate made of Al₂O₃ and the copper sheet were bonded to each other under the conditions shown in Tables 4, 5, and 6.

In addition, the ceramic substrate made of Al₂O₃ and the aluminum sheet were brazed under the bonding conditions of an applied pressured of 1.2 MPa (12 kgf/cm²), a heating temperature of 650°C, and a heating time of 30 minutes in a vacuum atmosphere. Further, the aluminum sheets were brazed under the bonding conditions of an applied pressured of 0.6 MPa (6 kgf/cm²), a heating temperature of 610°C, and a heating time of 30 minutes in a vacuum atmosphere.

The size of the ceramic substrate made of Al₂O₃ is shown in Tables 4, 5, and 6.

The size of the copper sheet was set to 37 mm × 37 mm × 0.3mm.

The size of the aluminum sheet serving as a metal layer was set to 37 mm × 37 mm × 2.1 mm in the case of the power module substrate with a heat sink and was set to 37 mm × 37 mm × 0.6 mm in the case of the power module substrate with a heat sink and a buffering plate.

The size of the aluminum sheet serving as a heat sink was set to 50 mm × 60 mm × 5 mm.

The size of the aluminum sheet serving as a buffering plate was set to 40 mm × 40 mm × 0.9 mm.

In Tables 4, 5, and 6, the structures and the production methods of the power module substrate, the power module substrates with a heat sink, and the power module substrates with a heat sink and a buffering plate formed using the above-described various pastes were described.

The structure "DBC" represents the power module substrate shown in FIG. 10.

The structure "H-1" represents the power module substrate with a heat sink shown in FIG. 11.

The structure "H-2" represents the power module substrate with a heat sink shown in FIG. 12.

The structure "B-1" represents the power module substrate with a heat sink shown in FIG. 13.

The structure "B-2" represents the power module substrate with a heat sink shown in FIG. 5.

**[Table 4]**

| | | Bonding condition | | Ceramic substrate | | Structure |
|---|---|---|---|---|---|---|
| | | Bonding temperature/°C | Load/MPa (kgf/cm²) | Material | Size | |
| | 1 | 790 | 0.6 (6) | Al₂0₃ | 40mm × 40mm × 0.635mm | H-1 |
| | 2 | 850 | 1.8 (18) | Al₂0₃ | 40mm × 40mm × 0.635mm | H-1 |
| | 3 | 820 | 1.2 (12) | Al₂0₃ | 40mm × 40mm × 0.635mm | H-1 |
| | 4 | 820 | 0.6 (6) | Al₂0₃ | 40mm × 40mm × 0.635mm | B-1 |
| | 5 | 820 | 1.8 (18) | Al₂0₃ | 40mm × 40mm × 0.635mm | B-1 |
| | 6 | 820 | 0.6 (6) | Al₂0₃ | 40mm × 40mm × 0.635mm | B-1 |
| | 7 | 820 | 0.6 (6) | Al₂0₃ | 40mm × 40mm × 0.635mm | DBC |
| | 8 | 850 | 0.6 (6) | Al₂0₃ | 40mm × 40mm × 0.635mm | DBC |
| | 9 | 790 | 0.6 (6) | Al₂0₃ | 40mm × 40mm × 0.635mm | B-2 |
| Example | 10 | 790 | 0.6 (6) | Al₂0₃ | 40mm × 40mm × 0.635mm | B-2 |
| | 11 | 790 | 0.6 (6) | Al₂0₃ | 40mm × 40mm × 0.635mm | B-2 |
| | 12 | 790 | 1.2 (12) | Al₂0₃ | 40mm × 40mm × 0.635mm | H-1 |
| | 13 | 820 | 0.6 (6) | Al₂0₃ | 40mm × 40mm × 0.635mm | H-1 |
| | 14 | 820 | 1.2 (12) | Al₂0₃ | 40mm × 40mm × 0.635mm | H-1 |
| | 15 | 820 | 1.2 (12) | Al₂0₃ | 40mm × 40mm × 0.635mm | H-2 |
| | 16 | 790 | 1.8 (18) | Al₂0₃ | 40mm × 40mm × 0.635mm | H-2 |
| | 17 | 820 | 1.2 (12) | Al₂0₃ | 40mm × 40mm × 0.635mm | H-2 |
| | 18 | 790 | 1.2 (12) | Al₂0₃ | 40mm × 40mm × 0.635mm | B-2 |
| | 19 | 790 | 1.8 (18) | Al₂0₃ | 40mm × 40mm × 0.635mm | B-2 |
| | 20 | 820 | 1.8 (18) | Al₂0₃ | 40mm × 40mm × 0.635mm | B-2 |
| Comparative Example | 1 | 850 | 1.8 (18) | Al₂0₃ | 40mm × 40mm × 0.635mm | DBC |
| | 2 | 850 | 1.2 (12) | Al₂0₃ | 40mm × 40mm × 0.635mm | H-2 |
| Conventional Example | 1 | 850 | 1.8 (18) | Al₂0₃ | 40mm × 40mm × 0.635mm | DBC |

**[Table 5]**

| | | Bonding condition | | Ceramic substrate | | Structure |
|---|---|---|---|---|---|---|
| | | Bonding temperature/°C | Load/MPa (kgf/cm²) | Material | Size | |
| | 51 | 850 | 1.2 (12) | Al₂0₃ | 40mm × 40mm × 0.635mm | H-2 |
| | 52 | 850 | 1.8 (18) | Al₂0₃ | 40mm × 40mm × 0.635mm | H-2 |
| | 53 | 850 | 1.8 (18) | Al₂0₃ | 40mm × 40mm × 0.635mm | H-2 |
| | 54 | 820 | 1.2 (12) | Al₂0₃ | 40mm × 40mm × 0.635mm | B-2 |
| | 55 | 850 | 1.2 (12) | Al₂0₃ | 40mm × 40mm × 0.635mm | B-2 |
| | 56 | 850 | 0.6 (6) | Al₂0₃ | 40mm × 40mm × 0.635mm | DBC |
| | 57 | 790 | 1.2 (12) | Al₂0₃ | 40mm × 40mm × 0.635mm | DBC |
| | 58 | 820 | 0.6 (6) | Al₂0₃ | 40mm × 40mm × 0.635mm | B-1 |
| | 59 | 820 | 0.6 (6) | Al₂0₃ | 40mm × 40mm × 0.635mm | B-1 |
| Example | 60 | 850 | 0.6 (6) | Al₂0₃ | 40mm × 40mm × 0.635mm | B-1 |
| | 61 | 850 | 0.6 (6) | Al₂0₃ | 40mm × 40mm × 0.635mm | H-1 |
| | 62 | 850 | 1.8 (18) | Al₂0₃ | 40mm × 40mm × 0.635mm | H-1 |
| | 63 | 820 | 1.2 (12) | Al₂0₃ | 40mm × 40mm × 0.635mm | H-1 |
| | 64 | 820 | 0.6 (6) | Al₂0₃ | 40mm × 40mm × 0.635mm | B-1 |
| | 65 | 820 | 1.2 (12) | Al₂0₃ | 40mm × 40mm × 0.635mm | B-1 |
| | 66 | 820 | 1.8 (18) | Al₂0₃ | 40mm × 40mm × 0.635mm | B-1 |
| | 67 | 790 | 1.8 (18) | Al₂0₃ | 40mm × 40mm × 0.635mm | B-2 |
| | 68 | 790 | 0.6 (6) | Al₂0₃ | 40mm × 40mm × 0.635mm | B-2 |
| | 69 | 850 | 1.2 (12) | Al₂0₃ | 40mm × 40mm × 0.635mm | H-2 |
| | 70 | 850 | 1.2 (12) | Al₂0₃ | 40mm × 40mm × 0.635mm | H-2 |
| Comparative Example | 51 | 850 | 0.6 (6) | Al₂0₃ | 40mm × 40mm × 0.635mm | B-1 |
| | 52 | 820 | 1.2 (12) | Al₂0₃ | 40mm × 40mm × 0.635mm | DBC |
| Conventional Example | 51 | 850 | 1.2 (12) | Al₂0₃ | 40mm × 40mm × 0.635mm | DBC |

**[Table 6]**

| | | Bonding condition | | Ceramic substrate | | Structure |
|---|---|---|---|---|---|---|
| | | Bonding temperature/°C | Load/MPa (kgf/cm²) | Material | Size | |
| Example | 81 | 850 | 1.2 (12) | Al₂0₃ | 40mm × 40mm × 0.635mm | H-1 |
| | 82 | 820 | 0.6 (6) | Al₂0₃ | 40mm × 40mm × 0.635mm | H-2 |
| | 83 | 790 | 1.8 (18) | Al₂0₃ | 40mm × 40mm × 0.635mm | B-2 |
| | 84 | 790 | 1.8 (12) | Al₂0₃ | 40mm × 40mm × 0.635mm | H-2 |
| | 85 | 850 | 0.6 (6) | Al₂0₃ | 40mm × 40mm × 0.635mm | B-2 |
| | 86 | 820 | 1.8 (18) | Al₂0₃ | 40mm × 40mm × 0.635mm | H-1 |

Here, the film thickness conversion amount (converted average film thickness) was measured and shown in Tables 7, 8, and 9 as below.

First, various pastes shown in Tables 1, 2, and 3 were applied to the interface between the ceramic substrate made of Al₂O₃ and the copper sheet and dried. In the dried various pastes, the film thickness conversion amount (converted average film thickness) of each element was measured.

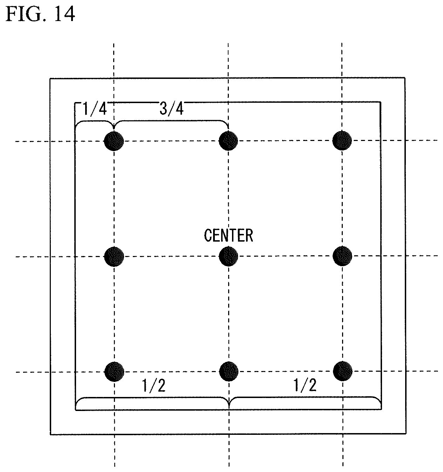

The film thickness was set to an average value obtained by measuring the film thickness of each of the applied various pastes using an X-ray fluorescent analysis thickness meter (STF9400, manufactured by SII NanoTechnology Inc.) at points (9 points) shown in FIG. 14 three times each and averaging the values. The film thickness was obtained in advance by measuring known samples and obtaining a relationship between the intensity of fluorescence X-rays and the density, and the film thickness conversion amount of each element was determined from the intensity of fluorescence X-rays measured in each sample based on the result.

**[Table 7]**

| | | Converted average film thickness/µm | | | | | | | | | | | | Eutectic layer thickness/µm |
|---|---|---|---|---|---|---|---|---|---|---|---|---|---|---|
| | | Ag | Cu | Ti | Zr | Hf | Nb | In | Sn | Mn | Al | Zn | Total | |
| | 1 | 1.06 | | 4.05 | | | | | | | | | 5.11 | 1 |
| | 2 | 1.21 | | 1.73 | | | | | | | | | 2.94 | 1 |
| | 3 | 14.35 | | 13.67 | | | | | | | | | 28.02 | 14 |
| | 4 | 10.16 | | 6.45 | | | | | | | | | 16.61 | 10 |
| | 5 | 12.92 | | 5.27 | | | | | | | | | 18.19 | 13 |
| | 6 | 14.86 | | 3.54 | | | | | | | | | 18.40 | 15 |
| | 7 | 10.75 | | 0.64 | | | | 1.92 | | | | | 13.31 | 11 |
| | 8 | 3.01 | | 0.18 | | | | | 0.54 | | | | 3.73 | 3 |
| | 9 | 2.29 | | 0.14 | | | | | | | 0.41 | | 2.84 | 2 |
| Example | 10 | 5.18 | | 0.31 | | | | | | 0.92 | | | 6.41 | 5 |
| | 11 | 8.73 | | 1.56 | | | | | | 0.52 | | | 10.81 | 9 |
| | 12 | 3.26 | | | 0.44 | | | 0.89 | | | | | 4.59 | 3 |
| | 13 | 4.61 | | | 0.63 | | | | | | 1.25 | | 6.49 | 4 |
| | 14 | 9.29 | | | 2.53 | | | | | | | 1.26 | 13.08 | 9 |
| | 15 | 9.57 | | | | 1.22 | | | 1.82 | | | | 12.61 | 9 |
| | 16 | 7.26 | | | | 1.84 | | | | | 0.46 | | 9.56 | 7 |
| | 17 | 6.41 | | | | 0.38 | | | | | | 1.15 | 7.94 | 6 |
| | 18 | 13.91 | | | | 6.62 | 2.21 | | | | | | 22.74 | 14 |
| | 19 | 5.34 | | | | | 0.85 | | 2.54 | | | | 8.73 | 5 |
| | 20 | 5.77 | | | | | 0.43 | | | | 0.18 | | 6.38 | 6 |
| Comparative Example | 1 | 24.31 | | 5.79 | | | | | | | | | 30.10 | 24 |
| | 2 | 28.70 | | 7.81 | | | | 3.90 | | | | | 40.41 | 28 |
| Conventional Example | 1 | 21.94 | 8.36 | 0.60 | | | | | | | | | 30.90 | 22 |

**[Table 8]**

| | | Converted average film thickness/µm | | | | | | | | | | | | Eutectic layer thickness/µm |
|---|---|---|---|---|---|---|---|---|---|---|---|---|---|---|
| | | Ag | Cu | Ti | Zr | Hf | Nb | In | Sn | Mn | Al | Zn | Total | |
| | 51 | 7.40 | | 21.15 | | | | | | | | | 28.55 | 7 |
| | 52 | 8.16 | | 20.39 | | | | | | | | | 28.55 | 8 |
| | 53 | 10.11 | | 1.07 | | | | | | | | | 11.18 | 10 |
| | 54 | 4.70 | | 0.24 | | | | | | | | | 4.94 | 5 |
| | 55 | 15.07 | | 0.29 | | | | | | | | | 15.36 | 15 |
| | 56 | 8.22 | | 0.08 | | | | | | | | | 8.30 | 8 |
| | 57 | 8.33 | | 0.03 | | | | | | | | | 8.36 | 8 |
| | 58 | 6.83 | | 0.93 | | | | 1.86 | | | | | 9.62 | 7 |
| | 59 | 5.28 | | 0.36 | | | | | | | | 1.79 | 7.43 | 5 |
| Example | 60 | 11.01 | | 1.50 | | | | | | | | 2.99 | 15.50 | 11 |
| | 61 | 7.27 | | | 4.61 | | | | | | | | 11.88 | 7 |
| | 62 | 15.80 | | | 7.53 | | | | 2.51 | | | | 25.84 | 15 |
| | 63 | 6.28 | | | 3.49 | | | | 0.50 | | | | 10.27 | 6 |
| | 64 | 10.21 | | | | 0.32 | | 0.76 | | | | | 11.29 | 10 |
| | 65 | 1.03 | | | | 0.04 | | | | 0.07 | | | 1.14 | 1 |
| | 66 | 7.04 | | | | 0.60 | | | | | 0.15 | | 7.79 | 7 |
| | 67 | 9.74 | | | | | 0.58 | | 1.74 | | | | 12.06 | 10 |
| | 68 | 2.44 | | | | | 0.23 | | | | | 0.35 | 3.02 | 2 |
| | 69 | 5.19 | | | | | 0.31 | | | 0.62 | | | 6.12 | 5 |
| | 70 | 5.98 | | | | | 0.60 | | | | 0.40 | | 6.98 | 6 |
| Comparative Example | 51 | 25.46 | | 10.39 | | | | | | | | | 35.85 | 25 |
| | 52 | 29.82 | | 8.12 | | | | | | 4.06 | | | 42.00 | 30 |
| Conventional Example | 51 | 23.12 | 8.81 | 0.63 | | | | | | | | | 32.56 | 23 |

**[Table 9]**

| | | Converted average film thickness/µm | | | | | | | | |
|---|---|---|---|---|---|---|---|---|---|---|
| | | Ag | Ti | Zr | In | Sn | Mn | Al | Zn | Total |
| Example | 81 | 3.55 | 0.45 | | | | | | 0.47 | 4.47 |
| | 82 | 6.14 | 0.38 | | | | | 0.72 | | 7.24 |
| | 83 | 2.46 | 0.49 | | | | 0.51 | | | 3.46 |
| | 84 | 3.09 | | 0.64 | | | | | | 3.73 |
| | 85 | 3.87 | | 1.12 | | 0.55 | | | | 5.54 |
| | 86 | 3.03 | | 0.41 | 0.62 | | | | | 4.06 |

In the power module substrate and the power module substrates with a heat sink obtained as described above, ceramic cracking, the bonding rate after loading of a thermal cycle, the formation of an oxide layer, and the thickness of the Ag-Cu eutectic structure layer were evaluated. The evaluation results are shown in Tables 10, 11, and 12.

The ceramic cracking was evaluated by confirming whether or not cracking occurred each of the 500 times a thermal cycle (from -45°C to 125°C) was repeated and counting the number of times in which cracking was confirmed.

The binding rate after loading of a thermal cycle was calculated using the power module substrate after a thermal cycle (from -45°C to 125°C) was repeated 4000 times by the following Equation. In a case in which cracking occurred when the number of thermal cycles repeated did not reach 3500 times, the bonding rate after the thermal cycle was repeated 4000 times was not evaluated.

Bonding rate = (Initial bonding area - Exfoliation area)/Initial bonding area

The formation of an oxide layer was confirmed by confirming whether or not the oxide-forming element was formed at the interface between the ceramic substrate made of Al₂O₃ and the copper sheet from the mapping of the oxide-forming element using an electron probe microanalyzer (EPMA). Through the above method, a case in which an oxide was observed, the case was denoted by "formed" and a case in which an oxide was not observed, the case was denoted by "not formed."

The thickness of the Ag-Cu eutectic structure layer was obtained by measuring the area of the Ag-Cu eutectic structure layer continuously formed at the bonding interface from a reflection electronic image at the interface between the ceramic substrate made of Al₂O₃ and the copper sheet obtained by using an electron probe microanalyzer (EPMA) in a visual field (vertical length 45 µm; horizontal length 60 µm) at a 2000-fold magnification, and obtaining a value by dividing the measured area by the size of the width of the measured visual field, and an average value of values in 5 visual fields was set to the thickness of the Ag-Cu eutectic structure layer. The area of the Ag-Cu eutectic structure layer excluding a region not continuously formed from the bonding interface in the thickness direction on the Ag-Cu eutectic structure layer formed at the portion in which the copper sheet and the ceramic substrate made of Al₂O₃ was measured.

**[Table 10]**

| | | Formation of oxide layer | Eutectic layer thickness/µm | Number of ceramic cracking cycles/times | Bonding rate (after 4000 cycles) |
|---|---|---|---|---|---|
| | 1 | Formed | 1 | 3500 - 4000 | 90.8% |
| | 2 | Formed | 1 | > 4000 | 98.5% |
| | 3 | Formed | 14 | > 4000 | 97.5% |
| | 4 | Formed | 10 | 3500 - 4000 | 91.3% |
| | 5 | Formed | 13 | > 4000 | 98.6% |
| | 6 | Formed | 15 | > 4000 | 97.4% |
| | 7 | Formed | 11 | 3000 - 3500 | Stopped in 3500th cycle |
| | 8 | Formed | 3 | 3500 - 4000 | 92.1% |
| | 9 | Formed | 2 | 3500 - 4000 | 90.4% |
| Example | 10 | Formed | 5 | > 4000 | 93.5% |
| | 11 | Formed | 9 | > 4000 | 94.1% |
| | 12 | Formed | 3 | > 4000 | 93.1% |
| | 13 | Formed | 4 | > 4000 | 99.1% |
| | 14 | Formed | 9 | > 4000 | 100.0% |
| | 15 | Formed | 9 | > 4000 | 98.4% |
| | 16 | Formed | 7 | > 4000 | 92.8% |
| | 17 | Formed | 6 | > 4000 | 96.4% |
| | 18 | Formed | 14 | 3500 - 4000 | 91.5% |
| | 19 | Formed | 5 | > 4000 | 93.8% |
| | 20 | Formed | 6 | > 4000 | 97.9% |
| Comparative Example | 1 | Formed | 24 | 1000 - 1500 | Stopped in 1500th cycle |
| | 2 | Formed | 28 | 1500 - 2000 | Stopped in 2000th cycle |
| Conventional Example | 1 | Formed | 22 | 1000 - 1500 | Stopped in 1500th cycle |

**[Table 11]**

| | | Formation of oxide layer | Eutectic layer thickness/µm | Number of cracking cycles/times | Bonding rate (after 4000 cycles) |
|---|---|---|---|---|---|
| | 51 | Formed | 7 | > 4000 | 100.0% |
| | 52 | Formed | 8 | > 4000 | 98.7% |
| | 53 | Formed | 10 | > 4000 | 99.4% |
| | 54 | Formed | 5 | 3500 - 4000 | 92.8% |
| | 55 | Formed | 15 | > 4000 | 98.6% |
| | 56 | Formed | 8 | 3000 - 3500 | Stopped in 3500th cycle |
| | 57 | Formed | 8 | 3000 - 3500 | Stopped in 3500th cycle |
| | 58 | Formed | 7 | > 4000 | 97.4% |
| Example | 59 | Formed | 5 | > 4000 | 98.2% |
| | 60 | Formed | 11 | > 4000 | 98.4% |
| | 61 | Formed | 7 | > 4000 | 99.7% |
| | 62 | Formed | 15 | > 4000 | 96.9% |
| | 63 | Formed | 6 | 3500 -4000 | 91.9% |
| | 64 | Formed | 10 | > 4000 | 98.2% |
| | 65 | Formed | 1 | > 4000 | 96.8% |
| | 66 | Formed | 7 | 3500 - 4000 | 92.5% |
| | 67 | Formed | 10 | > 4000 | 92.7% |
| | 68 | Formed | 2 | > 4000 | 94.4% |
| | 69 | Formed | 5 | > 4000 | 97.8% |
| | 70 | Formed | 6 | 3500 - 4000 | 95.1% |
| Comparative Example | 51 | Formed | 25 | 1500 - 2000 | Stopped in 2000th cycle |
| | 52 | Formed | 30 | 500 - 1000 | Stopped in 1000th cycle |
| Conventional Example | 51 | Formed | 23 | 1000 - 1500 | Stopped in 1500th cycle |

**[Table 12]**

| | | Formation of oxide layer | Eutectic layer thickness/µm | Number of cracking cycles/times | Bonding rate (after 4000 cycles) |
|---|---|---|---|---|---|
| Example | 81 | Formed | 3 | > 4000 | 98.9% |
| | 82 | Formed | 5 | 3500 - 4000 | 98.5% |
| | 83 | Formed | 2 | > 4000 | 96.3% |
| | 84 | Formed | 3 | > 4000 | 98.4% |
| | 85 | Formed | 3 | > 4000 | 97.6% |
| | 86 | Formed | 3 | > 4000 | 96.7% |

In Comparative Examples 1, 2, 51, and 52, the thickness of the eutectic structure layer was more than 15 µm and cracking occurred in the ceramic substrate made of Al₂O₃ in a small number of cycles.

In addition, in Conventional Examples 1 and 51, the thickness of the eutectic structure layer was more than 15 µm and cracking occurred in the ceramic substrate made of Al₂O₃ in a small number of cycles as in Comparative Examples.

On the other hand, in Examples 1 to 20, 51 to70, and 81 to 86 of the present invention in which the thickness of the eutectic structure layer was 15 µm or less, it was confirmed that occurrence of cracking was suppressed in the ceramic substrate made of Al₂O₃.

From the above results, according to the Examples of the present invention, it was confirmed that it was possible to provide a power module substrate capable of suppressing occurrence of cracking in the ceramic substrate made of Al₂O₃ during loading of a thermal cycle.

### INDUSTRIAL APPLICABILITY

According to the present invention, it is possible to provide a power module substrate obtained by bonding a copper sheet made of copper or a copper alloy to a ceramic substrate made of Al₂O₃ and capable of suppressing occurrence of cracking in the ceramic substrate during loading of a thermal cycle. In addition, a power module substrate with a heat sink and a power module with the above-described power module substrate can be provided.

### BRIEF DESCRIPTION OF SYMBOLS

1: Power module
3: Semiconductor element (electronic component)
10, 110, 210, 310, 410: Power module substrate
11, 111, 211, 311, 411: Ceramic substrate
12, 112, 212, 312, 412: Circuit layer
13, 113, 213, 313, 413: Metal layer
22, 122, 123, 222, 322, 422: Copper sheet
23, 223, 323, 423: Aluminum sheet
31, 131: Oxide layer
32: Ag-Cu Eutectic structure layer
41, 441: Buffering plate
50, 250, 350, 450: Power module substrate with heat sink
51, 251, 351, 451: Heat sink

## Claims

1. A power module substrate comprising: a ceramic substrate made of Al₂O₃; and a copper sheet made of copper or a copper alloy laminated and bonded onto a surface of the ceramic substrate, wherein
an oxide layer is formed on the surface of the ceramic substrate between the copper sheet and the ceramic substrate,
an Ag-Cu eutectic structure layer is formed on the oxide layer,
a thickness of the Ag-Cu eutectic structure layer is 15 µm or less, and
the oxide layer contains oxides of one or more elements selected from Ti, Hf, Zr, and Nb.

2. A power module substrate with a heat sink comprising:
the power module substrate according to Claim 1; and
a heat sink which is configured to cool the power module substrate.

3. A power module comprising:
the power module substrate according to Claim 1; and
an electronic component which is mounted on the power module substrate.

## Patentansprüche

1. Leistungsmodulsubstrat, umfassend: ein Keramiksubstrat aus Al₂O₃ und ein Kupferblech aus Kupfer oder einer Kupferlegierung, das auf einer Oberfläche des Keramiksubstrats laminiert und daran gebunden ist, wobei
eine Oxidschicht auf der Oberfläche des Keramiksubstrats zwischen dem Kupferblech und dem Keramiksubstrat gebildet ist,
eine eutektische Ag-Cu-Strukturschicht auf der Oxidschicht gebildet ist,
eine Dicke der eutektischen Ag-Cu-Strukturschicht 15 µm oder weniger beträgt und
die Oxidschicht Oxide von einem oder mehreren Elementen, ausgewählt aus der Gruppe, bestehend aus Ti, Hf, Zr und Nb, enthält.

2. Leistungsmodulsubstrat mit einem Kühlkörper, umfassend:
das Leistungsmodulsubstrat gemäß Anspruch 1 und
einen Kühlkörper, der so konfiguriert ist, dass er das Leistungsmodulsubstrat kühlt.

3. Leistungsmodul, umfassend:
das Leistungsmodulsubstrat gemäß Anspruch 1 und
ein elektronisches Bauteil, das an dem Leistungsmodulsubstrat montiert ist.

## Revendications

1. Substrat de module de puissance comprenant : un substrat en céramique réalisé en Al₂O₃ ; et une feuille de cuivre réalisée en cuivre ou en un alliage de cuivre stratifiée et collée sur une surface du substrat en céramique, dans lequel
une couche d'oxyde est formée sur la surface du substrat en céramique entre la feuille de cuivre et le substrat en céramique,
une couche de structure eutectique Ag-Cu est formée sur la couche d'oxyde,
une épaisseur de la couche de structure eutectique Ag-Cu est de 15 µm ou moins, et
la couche d'oxyde contient des oxydes d'un ou plusieurs éléments choisis parmi Ti, Hf, Zr et Nb.

2. Substrat de module de puissance avec un dissipateur thermique comprenant :
le substrat de module de puissance selon la revendication 1 ; et
un dissipateur thermique qui est configuré pour refroidir le substrat de module de puissance.

3. Module de puissance comprenant :
le substrat de module de puissance selon la revendication 1 ; et
un composant électronique qui est monté sur le substrat de module de puissance.
